# EUROPEAN PATENT APPLICATION

(11) **EP 4 535 929 A1**
(43) Date of publication of application: **09.04.2025**
(21) Application number: 24204498.0
(22) Date of filing: 03.10.2024
(51) Int. Cl.: H05K 1/02, H05K 1/11, H05K 3/40, H01T 4/08, H05K 9/00

(54) **MULTI-STRUCTURE CONNECTOR INCLUDING SPARK GAP**

(30) Priority: 05.10.2023 KR 20230132457
(71) Applicant: SAMSUNG SDI CO., LTD., Yongin-si, Gyeonggi-do 17084 (KR)
(72) Inventor: JEON, Peelsik, 17084 Yongin-si (KR); CHUNG, Mooil, 17084 Yongin-si (KR)
(74) Representative: Marks & Clerk LLP

(57) **Abstract**

A connector mounted on a printed circuit board includes a first layer including connector holes having an array structure of two or more columns allowing connector pins to be inserted thereinto, a spark gap between connector hole(s) of the plurality of connector holes and a ground of a printed circuit board, and a conductor line having an end connected to the connector hole(s), the conductor line being arranged between the ground of the printed circuit board and the connector hole(s), and a second layer stacked on a surface of the first layer including connector holes orthogonally spaced from and corresponding to the connector holes of the first layer, and a spark gap between a connector hole, among the plurality of connector holes of the second layer, corresponding to the connector hole(s) of the first layer, and a ground of the printed circuit board.

## Description

### BACKGROUND

### 1. Field

Embodiments relate to a multi-layer connector structure including a spark gap.

### 2. Description of the Related Art

An electrostatic discharge (ESD) test for a connector is a test wherein an ESD is applied to a protruding connector pin to examine a circuit board for damage, malfunction, etc. Generally, for protection against an ESD, an ESD capacitor and a transient voltage suppressor (TVS) are added to each connector pin or a connector spark gap is provided. In particular, a conventional connector with a spark gap includes a connector of a (1-Layer) structure. Thus, on a circuit board including a connector of a structure with two or more columns, conductor lines overlap in circuit design. This causes difficulties in circuit design and makes it difficult to employ such a spark gap.

### SUMMARY

Embodiments include a connector mounted on a printed circuit board, the connector including a first layer. The first layer includes a plurality of connector holes having an array structure of two or more columns allowing a connector pin to be inserted thereinto, a spark gap between at least one connector hole of the plurality of connector holes and a ground of a printed circuit board, and a conductor line having an end connected to the at least one connector hole, the conductor line being arranged between the ground of the printed circuit board and the at least one connector hole. The connector further includes a second layer stacked on a surface of the first layer, the second layer including a plurality of connector holes orthogonally spaced from and corresponding to the plurality of connector holes of the first layer, and a spark gap between a connector hole, among the plurality of connector holes of the second layer, corresponding to the at least one connector hole of the first layer, and a ground of the printed circuit board.

The connector may further include a third layer stacked with the first layer and the second layer. The third layer may include a plurality of connector holes orthogonally spaced from and corresponding to the plurality of connector holes of the first layer and the plurality of connector holes of the second layer.

The third layer may include a spark gap between a connector hole, among the plurality of connector holes of the third layer, corresponding to the at least one connector hole of the first layer, and the ground of the printed circuit board.

The connector may further include a fourth layer stacked with the first layer, the second layer, and the third layer. The fourth layer may include a plurality of connector holes orthogonally spaced from and corresponding to the plurality of connector holes of the first layer, the plurality of connector holes of the second layer, and the plurality of connector holes of the third layer.

The fourth layer may include a spark gap between a connector hole, among the plurality of connector holes of the fourth layer, corresponding to the at least one connector hole of the first layer, and the ground of the printed circuit board.

The spark gap may include a gap between the plurality of connector holes having an electrostatic discharge protection function and the ground of the printed circuit board.

The spark gap may include a gap between a ground protruding portion connected to the ground of the printed circuit board and a hole protruding portion protruding from a connector hole in a shape corresponding to the ground protruding portion.

The ground protruding portion and the hole protruding portion may each include a copper foil layer in a triangular patch shape facing each other.

A battery management system circuit board may include the connector.

The battery management system circuit board may further include a third layer stacked with the first layer and the second layer, the third layer including a plurality of connector holes orthogonally spaced from and corresponding to the plurality of connector holes of the first layer and the plurality of connector holes of the second layer.

The third layer may include a spark gap between a connector hole, among the plurality of connector holes of the third layer, corresponding to the at least one connector hole of the first layer, and the ground of the printed circuit board.

The battery management system circuit board may further include a fourth layer stacked with the first layer, the second layer, and the third layer, the fourth layer including a plurality of connector holes orthogonally spaced from and corresponding to the plurality of connector holes of the first layer, the plurality of connector holes of the second layer, and the plurality of connector holes of the third layer.

The fourth layer may include a spark gap between a connector hole, among the plurality of connector holes of the fourth layer, corresponding to the at least one connector hole of the first layer, and the ground of the printed circuit board.

The spark gap may include a gap between the plurality of connector holes having an electrostatic discharge protection function and the ground of the printed circuit board.

The spark gap may include a gap between a ground protruding portion connected to the ground of the printed circuit board and a hole protruding portion protruding from a connector hole in a shape corresponding to the ground protruding portion.

The ground protruding portion and the hole protruding portion may each include a copper foil layer in a triangular patch shape facing each other.

A battery pack may include the battery management system circuit board.

Embodiments include a multi-layer connector, the multi-layer connector including a first printed circuit board layer having a first plurality of connector holes in an array structure of two or more columns allowing connector pins to inserted thereinto, a first electrically conductive member coupled to the first printed circuit board layer at one or more first connector holes of the first plurality of connector holes, the first electrically conductive member being spaced apart from a second electrically conductive member connected to a ground of the first printed circuit board layer so as to create a first spark gap, a second printed circuit board layer stacked on a surface of the first printed circuit board layer, the second printed circuit board layer having a second plurality of connector holes orthogonally spaced from and lined up with the first plurality of connector holes, and a third electrically conductive member coupled to the second printed circuit board layer at one or more second connector holes of the second plurality of connector holes, the third electrically conductive member being spaced apart from a fourth electrically conductive member connected to a ground of the first printed circuit board layer so as to create a second spark gap.

The multi-layer connector may further include a third printed circuit board layer stacked with the first printed circuit board layer and the second circuit board layer, the third printed circuit board layer including a third plurality of connector holes orthogonally spaced from and lined up with the first plurality of connector holes and the second plurality of connector holes, and a fifth electrically conductive member coupled to the third printed circuit board layer at one or more third connector holes of the third plurality of connector holes, the fifth electrically conductive member being spaced apart from a sixth electrically conductive member connected to a ground of the third printed circuit board layer so as to create a third spark gap.

The multi-layer connector may further include a fourth printed circuit board layer stacked with the first printed circuit board layer, the second circuit board layer and the third circuit board layer, the fourth printed circuit board layer including a fourth plurality of connector holes orthogonally spaced from and lined up with the first plurality of connector holes, the second plurality of connector holes and the third plurality of connector holes, and a seventh electrically conductive member coupled to the fourth printed circuit board layer at one or more fourth connector holes of the fourth plurality of connector holes, the seventh electrically conductive member being spaced apart from an eighth electrically conductive member connected to a ground of the fourth printed circuit board layer so as to create a fourth spark gap.

At least some of the above and other features of the invention are set out in the claims.

### BRIEF DESCRIPTION OF THE DRAWINGS

Features will become apparent to those of ordinary skill in the art by describing in detail example embodiments with reference to the attached drawings, in which:
FIG. 1 is a view for describing a connector according to embodiments of the present disclosure;
FIGS. 2 and 3 schematically show a connector according to embodiments of the present disclosure; and
FIG. 4 is a view for describing a spark gap according to embodiments of the present disclosure.

### DETAILED DESCRIPTION

In the drawing figures, the dimensions of layers and regions may be exaggerated or reduced for clarity of illustration. It will also be understood that if a layer or element is referred to as being "on" another layer or substrate, it can be directly on the other layer or substrate, or intervening layers may also be present. Further, it will be understood that if a layer is referred to as being "under" another layer, it can be directly under, and one or more intervening layers may also be present. In addition, it will also be understood that if a layer is referred to as being "between" two layers, it can be the only layer between the two layers, or one or more intervening layers may also be present. Like reference numerals refer to like elements throughout.

Expressions such as "at least one of," if preceding a list of components, modify the entire list of components and do not modify the individual components of the list.

In the following embodiments, an x-axis, a y-axis, and a z-axis are not limited to three axes on an orthogonal coordinate system, and may be interpreted in a broad sense including them. For example, the x-axis, the y-axis, and the z-axis may be orthogonal to each other, but may also refer to different directions that are not orthogonal to each other.

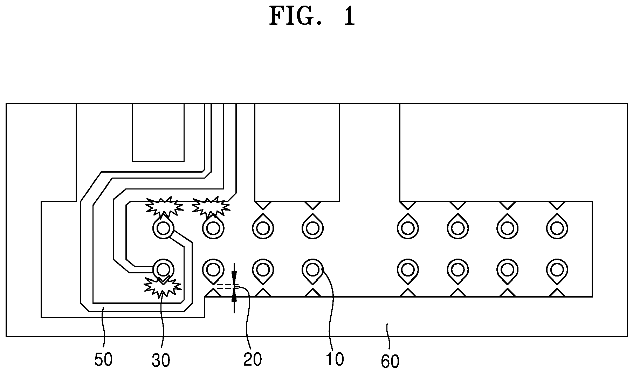

FIG. 1 is a view for describing a connector according to embodiments of the present disclosure.

Referring to FIG. 1, an example of a connector of a (1-Layer) structure is shown. For example, the connector may include connector pins inserted therein and arranged in a 2-column array structure.

The connector may include a plurality of connector holes 10 having a 2-column array structure into which the connector pins may be inserted.

Referring to FIG. 1, the connector may include a spark gap 20 between at least one connector hole 10 of the plurality of connector holes 10 and ground 60 of a printed circuit board.

The connector may include a conductor line 50 having an end connected to at least one connector hole 10. For example, referring to FIG. 1, the conductor line 50 may be connected to the at least one connector hole 10 and thus electrically connected to the connector pin. In a case of a connector with a structure of two or more columns including the conductor line 50, applying the spark gap 20 may be difficult due to an arrangement of the conductor line 50. For example, referring to FIG. 1, in the case of the connector having the structure of two or more columns, the conductor line 50 may be formed between the at least one connector hole 10 and the ground 60 of the printed circuit board such that the at least one connector hole 10 to which the spark gap 20 is not applied may be formed. In this case, if an ESD 30 is applied to the connector pin inserted into the connector hole 10 to which the spark gap 20 is not applied, a circuit board or components may be damaged by the ESD 30.

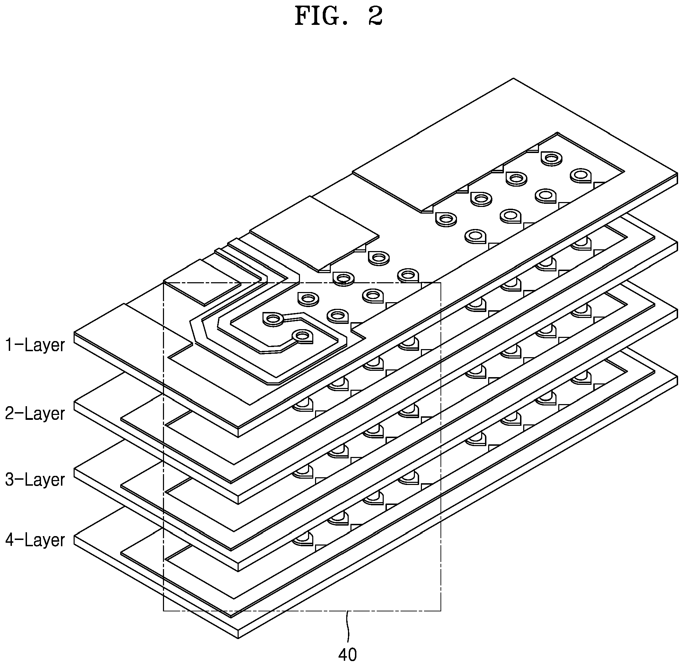

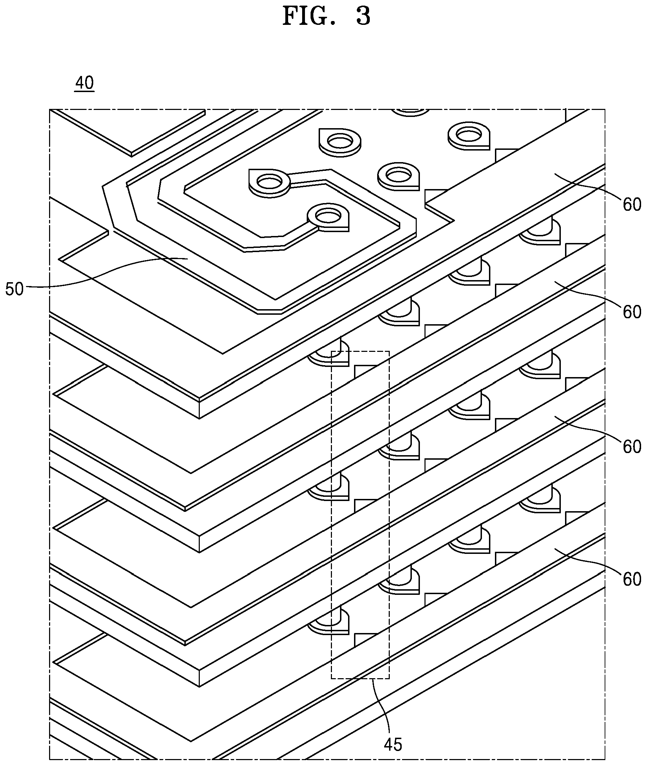

FIGS. 2 and 3 schematically show a connector according to embodiments of the present disclosure.

Referring to FIG. 2, a connector including four layers according to embodiments of the present disclosure is shown. It will be understood that more or fewer layers may be present. Referring to FIG. 3, an enlarged view of a partial section 40 of the connector of FIG. 2 is shown. For example, referring to a partial section 45 of FIG. 3, for the connector hole 10 not including the spark gap 20 in a first layer (1-Layer), the connector including the spark gap 20 in a second layer (2-Layer), a third layer (3-Layer), and a fourth layer (4-Layer) is shown.

In one layer of a connector including connector holes having a structure of two or more columns, the connector hole 10 to which the spark gap 20 is not applied may be formed. However, the connector according to embodiments of the present disclosure, including a multilayer structure, may form a spark gap in another layer for the connector hole 10 to which the spark gap 20 is not applied, thereby preventing damage caused by an ESD.

Referring to FIGS. 1 and 2, the connector according to embodiments of the present disclosure may be mounted on a printed circuit board. For example, a BMS circuit board according to embodiments of the present disclosure may include a printed circuit board having the connector according to the present disclosure mounted thereon. A battery pack according to embodiments of the present disclosure may include the printed circuit board having the connector according to the present disclosure mounted thereon.

The connector according to embodiments of the present disclosure may include the first layer (1-Layer) and the second layer (2-Layer). Herein, each of the first layer (1-Layer) and the second layer (2-Layer) may indicate one layer of the connector. Each of the first layer (1-Layer) and the second layer (2-Layer) may also indicate one layer of the printed circuit board. In this case, the connector according to embodiments of the present disclosure may indicate a connector of a structure where two layers may be stacked.

The first layer (1-Layer) may include the plurality of connector holes 10 having an array structure of two or more columns allowing the connector pin to be inserted thereinto. For example, referring to FIGS. 1 and 2, the first layer (1-Layer) may include the plurality of connector holes 10 having a 2-column array structure allowing the connector pin to be inserted thereinto. However, the present disclosure is not limited thereto, and the connector according to embodiments of the present disclosure may include the plurality of connector holes 10 having an array structure of two or more columns, such as three or four columns, etc.

The first layer (1 -Layer) may include the spark gap 20 between the at least one connector hole 10 and the ground 60 of the printed circuit board. A detailed description of the spark gap 20 will be provided later.

The first layer (1-Layer) may include the conductor line 50 having an end connected to the at least one connector hole 10. For example, the conductor line 50 may be a conductive pattern formed on the printed circuit board.

The second layer (2-Layer) may be arranged to be stacked on a surface (e.g., a top surface in the orientation of FIG. 2) of the first layer (1-Layer). For example, referring to FIG. 2, the second layer (2-Layer) may be arranged in parallel with the first layer (1-Layer) in such a way to be stacked under the first layer (1-Layer). The second layer (2-Layer) may be arranged in parallel with the first layer (1-Layer) in such a way to be stacked on the first layer (1 -Layer).

The second layer (2-Layer) may include the plurality of connector holes 10 orthogonally spaced from and corresponding to (e.g., lined up with) the plurality of connector holes 10 of the first layer (1-Layer). For example, referring to FIG. 2, the second layer (2-Layer) may include the plurality of connector holes 10 spaced from and corresponding to the plurality of connector holes 10 of the first layer (1-Layer) in a y-axis direction (e.g., if an x-axis is a major axis of the first layer (1-Layer)) orthogonal to the first layer (1-Layer). For example, the plurality of connector holes 10 may be formed to penetrate the first layer (1-Layer) and the second layer (2-Layer). In this case, the connector pin may be inserted into the connector hole 10 penetrating the first layer (1-Layer) and the second layer (2-Layer).

The second layer (2-Layer) may include the spark gap 20 between the connector hole 10 to correspond to the at least one connector hole 10 of the first layer (1-Layer), among the plurality of connector holes 10 of the second layer (2-Layer), and the ground 60 of the printed circuit board. For example, referring to FIGS. 2 and 3, the second layer (2-Layer) may include the spark gap 20 between the ground of the printed circuit board and the (or each) connector hole 10 of the second layer (2-Layer) corresponding to the (or each) connector hole 10 of the first layer (1-Layer) to which a spark gap is not applied due to the arrangement of the conductor line 50 between the ground 60 of the printed circuit board and the (or each) connector hole 10 of the first layer (1-Layer). More specifically, for the connector hole 10 of the second layer (2-Layer) corresponding to the (or each) connector hole 10 of the first layer (1-Layer) to which the spark gap is not applied due to the arrangement of the conductor line 50 between the ground 60 of the printed circuit board and the (or each) connector hole 10 of the first layer (1-Layer), the spark gap not included on the first layer (1-Layer) may be provided on the second layer (2-Layer).

The connector according to embodiments of the present disclosure may further include a third layer (3-Layer). In this case, the connector according to embodiments of the present disclosure may indicate a connector having a structure where three layers including the first layer (1-Layer) to the third layer (3-Layer) may be stacked.

The third layer (3-Layer) may be arranged to be stacked with the first layer (1-Layer) and the second layer (2-Layer). For example, referring to FIG. 2, the third layer (3-Layer) may be arranged in parallel with the first layer (1-Layer) and the second layer (2-Layer) in such a way to be stacked under the first layer (1-Layer) and the second layer (2-Layer). The third layer (3-Layer) may be arranged in parallel with the first layer (1-Layer) and the second layer (2-Layer) in such a way to be stacked on the first layer (1-Layer) and the second layer (2-Layer).

The third layer (3-Layer) may include the plurality of connector holes 10 orthogonally spaced from and corresponding to the plurality of connector holes 10 of each of the first layer (1-Layer) and the second layer (2-Layer). For example, referring to FIG. 2, the third layer (3-Layer) may include the plurality of connector holes 10 spaced from and corresponding to the plurality of connector holes 10 of each of the first layer (1-Layer) and the second layer (2-Layer) in a y-axis direction (e.g., if the major axis of the first layer (1-Layer) is the x-axis) orthogonal to the first layer (1-Layer) and the second layer (2-Layer). For example, the plurality of connector holes 10 may be formed to penetrate the first layer (1-Layer), the second layer (2-Layer), and the third layer (3-Layer). In this case, the connector pin may be inserted into the connector hole 10 penetrating the first layer (1-Layer), the second layer (2-Layer), and the third layer (3-Layer).

The third layer (3-Layer) may include the spark gap 20 between the connector hole 10 corresponding to the at least one connector hole 10 of the first layer (1-Layer), among the plurality of connector holes 10 of the third layer (3-Layer), and the ground 60 of the printed circuit board. For example, referring to FIGS. 2 and 3, the third layer (3-Layer) may include the spark gap 20 between the ground 60 of the printed circuit board and the (or each) connector hole 10 of the third layer (3-Layer) corresponding to the (or each) connector hole 10 of the first layer (1-Layer) to which the spark gap 20 is not applied due to the arrangement of the conductor line 50 between the ground 60 of the printed circuit board and the (or each) connector hole 10 of the first layer (1-Layer). More specifically, for the connector hole 10 of the third layer (3-Layer) corresponding to the (or each) connector hole 10 of the first layer (1-Layer) to which the spark gap 20 is not applied due to the arrangement of the conductor line 50 between the ground 60 of the printed circuit board and the (or each) connector hole 10 of the first layer (1-Layer), the spark gap 20 not included on the first layer (1-Layer) may be provided on the third layer (3-Layer). In this case, the spark gap 20 not provided on the first layer (1-Layer) may be provided on the second layer (2-Layer) and the third layer (3-Layer), thereby dually preventing a damage from occurring due to an ESD.

The connector according to embodiments of the present disclosure may further include the fourth layer (4-Layer). In this case, the connector according to embodiments of the present disclosure may provide a connector having a structure where four layers including the first layer (1-Layer) to the fourth layer (4-Layer) may be stacked.

The fourth layer (4-Layer) may be stacked with the first layer (1-Layer), the second layer (2-Layer), and the third layer (3-Layer). For example, referring to FIG. 2, the fourth layer (4-Layer) may be arranged in parallel with the first layer (1-Layer), the second layer (2-Layer), and the third layer (3-Layer) in such a way to be stacked under the first layer (1-Layer), the second layer (2-Layer), and the third layer (3-Layer). The fourth layer (4-Layer) may be arranged in parallel with the first layer (1-Layer), the second layer (2-Layer), and the third layer (3-Layer) in such a way to be stacked on the first layer (1-Layer), the second layer (2-Layer), and the third layer (3-Layer).

The fourth layer (4-Layer) may include the plurality of connector holes 10 orthogonally spaced from and corresponding to the plurality of connector holes 10 of each of the first layer (1-Layer), the second layer (2-Layer), and the third layer (3-Layer). For example, referring to FIG. 2, the fourth layer (4-Layer) may include the plurality of connector holes 10 spaced from and corresponding to the plurality of connector holes 10 of each of the first layer (1-Layer), the second layer (2-Layer), and the third layer (3-Layer) in the y-axis direction (e.g., if the major axis of the first layer is the x-axis) orthogonal to the first layer (1-Layer), the second layer (2-Layer), and the third layer (3-Layer). For example, the plurality of connector holes 10 may be formed to penetrate the first layer (1-Layer), the second layer (2-Layer), the third layer (3-Layer), and the fourth layer (4-Layer). In this case, the connector pin may be inserted into the connector hole 10 penetrating the first layer (1-Layer), the second layer (2-Layer), the third layer (3-Layer), and the fourth layer (4-Layer).

The fourth layer (4-Layer) may include the spark gap 20 between the connector hole 10 corresponding to the at least one connector hole 10 of the first layer (1-Layer), among the plurality of connector holes 10 of the fourth layer (4-Layer), and the ground 60 of the printed circuit board. For example, referring to FIGS. 2 and 3, the fourth layer (4-Layer) may include the spark gap 20 between the ground 60 of the printed circuit board and the (or each) connector hole 10 of the fourth layer (4-Layer) corresponding to the (or each) connector hole 10 of the first layer (1-Layer) to which a spark gap is not applied due to the arrangement of the conductor line 50 between the ground 60 of the printed circuit board and the (or each) connector hole 10 of the first layer (1-Layer). More specifically, for the connector hole 10 of the fourth layer (4-Layer) corresponding to the (or each) connector hole 10 of the first layer (1-Layer) to which the spark gap 20 is not applied due to the arrangement of the conductor line 50 between the ground 60 of the printed circuit board and the (or each) connector hole 10 of the first layer (1-Layer), the spark gap 20 not included on the first layer (1-Layer) may be provided on the fourth layer (4-Layer). In this case, the spark gap 20 not provided on the first layer (1-Layer) may be provided on the second layer (2-Layer), the third layer (3-Layer), and the fourth layer (4-Layer), thereby triply preventing a damage from occurring due to an ESD.

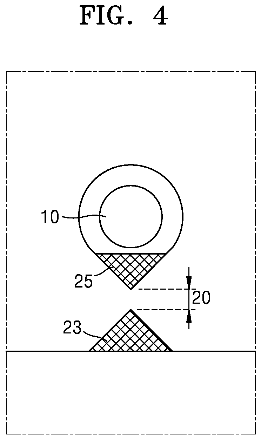

FIG. 4 is a view for describing a spark gap according to embodiments of the present disclosure.

Referring to FIG. 4, the spark gap 20 according to embodiments of the present disclosure may include a gap between the connector hole 10 having an ESD protection function and the ground 60 of the printed circuit board.

For example, referring to FIG. 4, the spark gap 20 may include a gap between a ground protruding portion 23 connected to the ground 60 of the printed circuit board and a hole protruding portion 25 connected to the connector hole 10 in a shape corresponding to the ground protruding portion 23.

For example, the ground protruding portion 23 and the hole protruding portion 25 may each include a copper foil layer in a triangular patch shape facing or pointing to each other.

According to embodiments of the present disclosure, if the connector hole 10 is surrounded by the conductor line 50, the spark gap 20 may not be arranged on the first layer (1 -Layer), such that the connector according to embodiments of the present disclosure may include the spark gap 20 on the second to fourth layers (2-Layer to 4-Layer), thereby preventing a damage from occurring due to an ESD.

Although the present disclosure has been described with reference to an example shown in the drawings, it will be understood by those of ordinary skill in the art that various modifications and equivalent other examples may be made from the shown example within the scope of the appended claims.

Those of ordinary skill in the art to which the present disclosure pertains will appreciate that the present disclosure may be implemented in different detailed ways without departing from the essential characteristics of the present disclosure. Accordingly, the aforementioned embodiments should be construed as being only illustrative, but should not be constructed as being restrictive from all aspects. For example, each element described as a single type may be implemented in a distributed manner, and likewise, elements described as being distributed may be implemented as a coupled type.

The scope of the present disclosure is defined by the following claims rather than the detailed description, and the meanings and scope of the claims and all changes or modified forms derived from their equivalents should be construed as falling within the scope of the present disclosure.

According to the present disclosure, by applying a spark gap to a connector with a structure of two or more columns, resistance to chronic ESD problems may be strengthened, and ESD reduction components such as an ESD capacitor, TVS, etc., may be reduced. However, the scope of the present disclosure is not limited by these effects.

Example embodiments have been disclosed herein, and although specific terms may be employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A connector mounted on a printed circuit board, the connector comprising:
a first layer including:
a plurality of connector holes having an array structure of two or more columns allowing connector pins to be inserted thereinto;
a spark gap between at least one connector hole of the plurality of connector holes and a ground of a printed circuit board; and
a conductor line having an end connected to the at least one connector hole, the conductor line being arranged between the ground of the printed circuit board and the at least one connector hole; and
a second layer stacked on a surface of the first layer, the second layer including:
a plurality of connector holes orthogonally spaced from and corresponding to the plurality of connector holes of the first layer; and
a spark gap between a connector hole, among the plurality of connector holes of the second layer, corresponding to the at least one connector hole of the first layer, and a ground of the printed circuit board.

2. The connector as claimed in claim 1, further comprising a third layer stacked with the first layer and the second layer, the third layer including a plurality of connector holes orthogonally spaced from and corresponding to the plurality of connector holes of the first layer and the plurality of connector holes of the second layer.

3. The connector as claimed in claim 2, wherein the third layer includes a spark gap between a connector hole, among the plurality of connector holes of the third layer, corresponding to the at least one connector hole of the first layer, and the ground of the printed circuit board.

4. The connector as claimed in claim 2 or 3, further comprising a fourth layer stacked with the first layer, the second layer, and the third layer, the fourth layer including a plurality of connector holes orthogonally spaced from and corresponding to the plurality of connector holes of the first layer, the plurality of connector holes of the second layer, and the plurality of connector holes of the third layer.

5. The connector as claimed in claim 4, wherein the fourth layer includes a spark gap between a connector hole, among the plurality of connector holes of the fourth layer, corresponding to the at least one connector hole of the first layer, and the ground of the printed circuit board.

6. The connector as claimed in any preceding claim, wherein the spark gap comprises a gap between each of the plurality of connector holes having an electrostatic discharge protection function and the ground of the printed circuit board.

7. The connector as claimed in claim 6, wherein the spark gap includes a gap between a ground protruding portion connected to the ground of the printed circuit board and a hole protruding portion protruding from a connector hole in a shape corresponding to the ground protruding portion.

8. The connector as claimed in claim 7, wherein the ground protruding portion and the hole protruding portion each include a copper foil layer in a triangular patch shape facing each other.

9. A battery management system circuit board including the connector as claimed in any preceding claim.

10. A battery pack including the battery management system circuit board as claimed in claim 9.

11. A multi-layer connector, comprising:
a first printed circuit board layer having a first plurality of connector holes in an array structure of two or more columns allowing connector pins to be inserted thereinto;
a first electrically conductive member coupled to the first printed circuit board layer at one or more first connector holes of the first plurality of connector holes, the first electrically conductive member being spaced apart from a second electrically conductive member connected to a ground of the first printed circuit board layer so as to create a first spark gap;
a second printed circuit board layer stacked on a surface of the first printed circuit board layer, the second printed circuit board layer having a second plurality of connector holes orthogonally spaced from and lined up with the first plurality of connector holes; and
a third electrically conductive member coupled to the second printed circuit board layer at one or more second connector holes of the second plurality of connector holes, the third electrically conductive member being spaced apart from a fourth electrically conductive member connected to a ground of the first printed circuit board layer so as to create a second spark gap.

12. The multi-layer connector as claimed in claim 11, further comprising:
a third printed circuit board layer stacked with the first printed circuit board layer and the second circuit board layer, the third printed circuit board layer including a third plurality of connector holes orthogonally spaced from and lined up with the first plurality of connector holes and the second plurality of connector holes; and
a fifth electrically conductive member coupled to the third printed circuit board layer at one or more third connector holes of the third plurality of connector holes, the fifth electrically conductive member being spaced apart from a sixth electrically conductive member connected to a ground of the third printed circuit board layer so as to create a third spark gap.

13. The multi-layer connector as claimed in claim 12, further comprising:
a fourth printed circuit board layer stacked with the first printed circuit board layer, the second circuit board layer and the third circuit board layer, the fourth printed circuit board layer including a fourth plurality of connector holes orthogonally spaced from and lined up with the first plurality of connector holes, the second plurality of connector holes and the third plurality of connector holes; and
a seventh electrically conductive member coupled to the fourth printed circuit board layer at one or more fourth connector holes of the fourth plurality of connector holes, the seventh electrically conductive member being spaced apart from an eighth electrically conductive member connected to a ground of the fourth printed circuit board layer so as to create a fourth spark gap.
